# EUROPÄISCHE PATENTSCHRIFT

(11) **EP 3 211 913 B1**
(45) Veröffentlichungstag und Bekanntmachung des Hinweises auf die Patenterteilung: **15.08.2018**
(21) Anmeldenummer: 17000168.9
(22) Anmeldetag: 02.02.2017
(51) Int. Cl.: H04Q 9/00, G08C 23/04, H03K 17/94, H03K 17/96

(54) **SENSORSCHALTUNG MIT MEHREREN OPTISCHEN SENSOREN**
SENSOR CIRCUIT WITH SEVERAL OPTICAL SENSORS
CIRCUIT DE CAPTEURS AVEC PLUSIEURS CAPTEURS OPTIQUES

(30) Priorität: 23.02.2016 DE 102016002138
(43) Veröffentlichungstag der Anmeldung: 30.08.2017
(73) Patentinhaber: Diehl AKO Stiftung & Co. KG, 88239 Wangen (DE)
(72) Erfinder: KOT, Krzysztof, PL - 50-55 Wroclaw (PL); Siesicki, Michal, PL - 52-129 Wroclaw (PL); Betiuk, Jakub, PL - 99-400 Lowicz (PL); Kurek, Jerzy, PL - 51-676 Wroclaw (PL)
(74) Vertreter: Diehl Patentabteilung

(56) Entgegenhaltungen:
- EP-A1- 1 703 641
- DE-A1-102010 013 327

## Beschreibung

Die vorliegende Erfindung betrifft eine Sensorschaltung mit mehreren optischen Sensoren, insbesondere für eine berührungs- und/oder annäherungsempfindliche Bedienvorrichtung.

Berührungs- und/oder annäherungsempfindliche Bedienvorrichtungen ("Touch Control") zum Beispiel für elektronische Haushaltsgeräte weisen in der Regel eine Anzahl entsprechender Bedienelemente auf. Die berührungs- und/oder annäherungsempfindlichen Bedienelemente arbeiten zum Beispiel nach einem optischen, kapazitiven, induktiven oder piezoelektrischen Funktionsprinzip. Im Fall von optischen Bedienelementen ist diesen eine Sensorschaltung mit optischen Sensoren zugeordnet. Bei optischen Sensoren besteht grundsätzlich die Gefahr einer fehlerhaften Signalauswertung durch Umgebungslicht (Sonnenlicht, künstliche Lichtquellen, etc.) und Übersprechen benachbarter Sensoren.

Das Dokument EP 1 703 641 A1 offenbart eine elektrische Schaltvorrichtung mit wenigstens einem berührungsempfindlichen Tastschalter mit einem optischen Sensor bereitzustellen, die eine verbesserte Funktionssicherheit besitzt.

Der Erfindung liegt die Aufgabe zugrunde, eine verbesserte Sensorschaltung mit mehreren optischen Sensoren zu schaffen, die einfach aufgebaut ist und eine Signalauswertung mit geringer Fehlerquote ermöglicht.

Diese Aufgabe wird gelöst durch eine Sensorschaltung mit mehreren optischen Sensoren mit den Merkmalen des Anspruchs 1. Besonders bevorzugte Ausgestaltungen und Weiterbildungen der Erfindung sind Gegenstand der abhängigen Ansprüche.

Die erfindungsgemäße Sensorschaltung mit mehreren optischen Sensoren weist einen ersten optischen Sensor mit einem ersten optischen Sender und einem ersten optischen Empfänger, wobei der erste optische Sender mit einem ersten Steuersignaleingang verbunden ist und der erste optische Empfänger mit einem ersten Messsignalausgang verbunden ist, und einen zweiten optischen Sensor mit einem zweiten optischen Sender und einem zweiten optischen Empfänger, wobei der zweite optische Sender mit einem zweiten Steuersignaleingang verbunden ist und der zweite optische Empfänger mit einem zweiten Messsignalausgang verbunden ist, auf. Der erste optische Empfänger und der zweite optische Empfänger sind mit einem gemeinsamen Steuersignaleingang verbunden. Eine erste Modulationseinrichtung zum Modulieren eines ersten Messsignals des ersten optischen Empfängers mit einem ersten Modulationsfaktor ist zwischen den ersten optischen Empfänger und den ersten Messsignalausgang geschaltet, und eine zweite Modulationseinrichtung zum Modulieren eines zweiten Messsignals des zweiten optischen Empfängers mit einem zweiten Modulationsfaktor, der von dem ersten Modulationsfaktor verschieden ist, ist zwischen den zweiten optischen Empfänger und den zweiten Messsignalausgang geschaltet.

Durch die Modulationseinrichtungen können die Messsignale der optischen Empfänger der verschiedenen optischen Sensoren mit unterschiedlichen Modulationsfaktoren moduliert und so auf einfache Weise voneinander unterschieden werden. Im Ergebnis kann die Sensorschaltung unter Beibehaltung der erforderlichen Sicherheitsstandards für mehrere Bedienelemente mit einer kleineren Anzahl an aktiven und passiven Bauelementen als herkömmliche Sensorschaltungen aufgebaut werden. Außerdem können durch die erfindungsgemäße Sensorschaltung vorzugsweise Prozessoren mit einer kleineren Anzahl an GPIO (General Purpose Input/Output) - Kontaktstiften verwendet werden.

Die Sensorschaltung weist wenigstens einen ersten optischen Sensor und einen zweiten optischen Sensor auf. Die Anzahl der optischen Sensoren ist grundsätzlich beliebig und kann insbesondere auch größer als zwei sein. Die optischen Sensoren weisen jeweils einen optischen Sender, vorzugsweise einen IR (Infrarot) - Sender, bevorzugt in Form einer Photodiode, und einen optischen Empfänger, vorzugsweise einen IR-Empfänger, bevorzugt in Form eines Phototransistors, auf.

Unter einem Modulieren mit einem Modulationsfaktor soll in diesem Zusammenhang jede Art einer vordefinierten Signalveränderung verstanden werden. Dabei kann es sich beispielsweise um ein Verschieben der Signalstärke um einen Signalpegel, um ein Multiplizieren der Signalstärke mit einem Faktor, um eine Frequenzänderung des Signals und dergleichen handeln.

Die verschiedenen Modulationseinrichtungen erzeugen vorzugsweise Messsignale, die sich möglichst geringfügig voneinander unterscheiden, aber eine eindeutige Identifizierung erlauben, von welchem optischen Empfänger das jeweilige Messsignal stammt.

In einer bevorzugten Ausgestaltung der Erfindung weist die erste Modulationseinrichtung einen ersten Spannungsteiler mit einem ersten Spannungsteilungsverhältnis auf und weist die zweite Modulationseinrichtung einen zweiten Spannungsteiler mit einem zweiten Spannungsteilungsverhältnis, das von dem ersten Spannungsteilungsverhältnis verschieden ist, auf.

Vorzugsweise weist der erste Spannungsteiler einen ersten Widerstand und einen zweiten Widerstand auf und weist der zweite Spannungsteiler einen ersten Widerstand und einen zweiten Widerstand auf, wobei die zweiten Widerstände des ersten und des zweiten Spannungsteilers unterschiedliche Widerstandswerte haben. Bevorzugt haben ihre ersten Widerstände den gleichen Widerstandswert, sodass nur die zweiten Widerstände in der Sensorschaltung unterschiedlich sein müssen.

In einer bevorzugten Ausgestaltung der Erfindung ist eine erste Filtereinrichtung zwischen den ersten optischen Empfänger und den ersten Messsignalausgang geschaltet, und ist eine zweite Filtereinrichtung zwischen den zweiten optischen Empfänger und den zweiten Messsignalausgang geschaltet.

Die Filtereinrichtungen weisen vorzugsweise jeweils eine Tiefpassfilterschaltung auf. Die Filtereinrichtungen sind vorzugsweise zwischen die Modulationseinrichtungen und die Messsignalausgänge geschaltet, d.h. den Modulationseinrichtungen nachgeschaltet.

In einer bevorzugten Ausgestaltung der Erfindung sind die Messsignalausgänge der optischen Empfänger jeweils mit einem ADC-Kanal eines Mikrocontrollers verbunden. In einer anderen bevorzugten Ausgestaltung der Erfindung sind die Messsignalausgänge der optischen Empfänger jeweils mit einem Eingang eines (analogen) Multiplexers verbunden. Die erfindungsgemäße Sensorschaltung mit ihren Modulationseinrichtungen erlaubt die Verwendung eines analogen Multiplexers unter gleichzeitiger Einhaltung der Sicherheitsstandards.

In einer weiteren bevorzugten Ausgestaltung der Erfindung sind die optischen Sender der optischen Sensoren mit einem gemeinsamen Fehlersignalausgang verbunden.

Gegenstand der Erfindung ist auch eine Bedienvorrichtung mit mehreren berührungs- und/oder annäherungsempfindlichen Bedienelementen, die eine oben beschriebene Sensorschaltung der Erfindung aufweist. Diese Bedienvorrichtung ist insbesondere in elektronischen Haushaltsgeräten wie beispielsweise Kochfeldern, Herden, Mikrowellenöfen, Spülmaschinen, Wäschebehandlungsgeräten, Kühl- und/oder Gefriergeräten und dergleichen vorteilhaft einsetzbar.

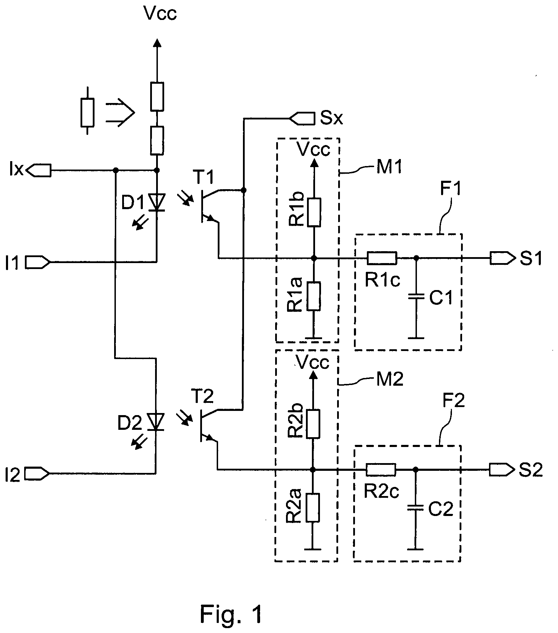

Obige sowie weitere Merkmale und Vorteile der Erfindung werden aus der nachfolgenden Beschreibung eines bevorzugten, nicht-einschränkenden Ausführungsbeispiels anhand der beiliegenden Zeichnung besser verständlich. Darin zeigt die einzige Figur 1 ein Blockschaltbild einer Sensorschaltung gemäß der vorliegenden Erfindung.

Fig. 1 zeigt eine Sensorschaltung mit zwei optischen Sensoren für eine Bedienvorrichtung mit zwei berührungs- und/oder annäherungsempfindlichen Bedienelementen. Die in Fig. 1 gezeigte Schaltungsanordnung kann vom Fachmann jedoch problemlos auf eine größere Anzahl optischer Sensoren erweitert werden.

Der erste optische Sensor weist eine IR-Photodiode als ersten optischen Sender D1 und einen IR-Phototransistor als ersten optischen Empfänger T1 auf, und der zweite optische Sensor weist eine IR-Photodiode als zweiten optischen Sender D2 und einen IR-Phototransistor als zweiten optischen Empfänger T2 auf. Die optischen Sender D1, D2 sind jeweils einerseits mit einer Referenzspannung Vcc und andererseits mit einem Steuersignaleingang I1, I2 verbunden. Über die Steuersignaleingänge I1, I2, die beispielsweise mit GPIO-Kontakten eines Mikrocontrollers (nicht dargestellt) verbunden sind, werden die optischen Sender D1, D2 vorzugsweise nacheinander getaktet aktiviert.

Außerdem sind die optischen Sender D1, D2 mit einem gemeinsamen Fehlersignalausgang Ix verbunden, der beispielsweise mit einem ADC-Kanal eines Mikrocontrollers (nicht dargestellt) verbunden ist. Zusätzlich ist ein gemeinsamer Shunt-Widerstand vorgesehen. Falls das Fehlersignal am Fehlersignalausgang Ix bei aktiviertem optischem Sender D1, D2 von einem vorbestimmten Wert abweicht, kann daraus auf eine Fehlfunktion des jeweiligen optischen Senders D1, D2 geschlossen werden.

Die optischen Empfänger T1, T2 sind einerseits mit einem gemeinsamen Steuersignaleingang Sx und andererseits jeweils mit einem Messsignalausgang S1, S2 verbunden. Zwischen die optischen Empfänger T1, T2 und die Messsignalausgänge S1, S2 ist jeweils eine Filtereinrichtung F1, F2 geschaltet. In dem gezeigten Ausführungsbeispiel sind die Filtereinrichtungen F1, F2 jeweils als Tiefpassfilterschaltungen mit einem Widerstand R1c, R2c und einer Kapazität C1, C2 ausgestaltet. Diese Tiefpassfilterschaltungen können insbesondere dann vorteilhaft sein, wenn die Messsignale einem Signaleingang mit hoher Eingangsimpedanz zugeleitet werden.

Die Messsignalausgänge S1, S2 können zum Beispiel jeweils mit einem ADC-Kanal eines Mikrocontrollers oder einem Eingang eines analogen Multiplexers, der ausgangsseitig mit einem ADC-Kanal eines Mikrocontrollers verbunden sein kann, verbunden werden.

Um die an den Messsignalausgängen S1, S2 bereitgestellten Messsignale der verschiedenen optischen Empfänger T1, T2 sicher voneinander unterscheiden zu können, sind den optischen Empfängern T1, T2 Modulationseinrichtungen M1, M2 zugeordnet. Die Modulationseinrichtungen M1, M2 sind beispielsweise jeweils zwischen einen optischen Empfänger T1, T2 und seine zugehörige Filtereinrichtung F1, F2 geschaltet.

Die verschiedenen Modulationseinrichtungen M1, M2 modulieren die von den optischen Empfängern T1, T2 bereitgestellten Messsignale mit unterschiedlichen Modulationsfaktoren. In dem gezeigten Ausführungsbeispiel sind die Modulationseinrichtungen zu diesem Zweck jeweils als Spannungsteiler ausgestaltet, um die Signalpegel der Messsignale zu verschieben. Diese Spannungsteiler weisen jeweils einen ersten Widerstand R1a, R2a und einen zweiten Widerstand R1b, R2b auf. Beispielsweise können die ersten Widerstände R1a, R2a Widerstände mit einem gleichen Widerstandswert sein, während sich die Widerstandswerte der zweiten Widerstände R1b, R2b leicht voneinander unterscheiden.

Anhand der unterschiedlich modulierten Messsignale kann der angeschlossene Mikrocontroller einfach erkennen, von welchem der optischen Sensoren das jeweilige Messsignal stammt. Beim Design der Spannungsteiler sollte darauf geachtet werden, dass der maximale Spannungswert so niedrig wie möglich ist, wobei Toleranzen der Widerstandswerte und die Genauigkeit der nachfolgenden Analog-Digital-Umsetzung ebenfalls berücksichtigt werden müssen.

Mit dieser Sensorschaltung können die gewünschten Sicherheitsstandards für mehrere berührungs- und/oder annäherungsempfindliche Bedienelemente bei einfachem Aufbau eingehalten werden. Die Sensorschaltung erlaubt dabei sogar die Verwendung eines analogen Multiplexers, sodass ein Mikrocontroller mit einer kleineren Anzahl von ADC-Kanälen benutzt werden kann. Außerdem kann die Sensorschaltung mit einer deutlich reduzierten Anzahl an aktiven Bauelementen (Transistoren, Dioden, etc.) und an passiven Bauelementen (Widerstände, Kapazitäten, etc.) und somit kostengünstiger aufgebaut werden.

Ferner können mit dieser Sensorschaltung auf einfache Weise Funktionstests durchgeführt werden. Zur Prüfung der Empfänger kann zum Beispiel zunächst bei ausgeschalteten Empfängern T1, T2 die Messspannung an jedem Messsignalausgang S1, S2 geprüft werden. Anschließend werden die optischen Empfänger T1, T2 über den gemeinsamen Steuersignaleingang Sx aktiviert, ohne dass auch die optischen Sender D1, D2 aktiviert werden. Falls eine Messspannung an einem Messsignalausgang S1, S2 nahe an der Referenzspannung Vcc liegt, kann darauf geschlossen werden, dass ein Kurzschluss am jeweiligen Phototransistor vorliegt. Bei positivem Testergebnis können anschließend die optischen Sender D1, D2 aktiviert werden. Die Messspannungen an den Messsignalausgängen S1, S2 sollten dann höher als bi ausgeschalteten Sendern D1, D2 liege, andernfalls kann auf eine Unterbrechung im Messsignalpfad auf der Empfängerseite geschlossen werden.

### BEZUGSZIFFERNLISTE

- Dn: optischer Sender, insbesondere Photodiode
- Fn: Filtereinrichtung
- In: Steuersignaleingang Sender Dn
- Ix: Fehlersignalausgang Sender
- Mn: Modulationseinrichtung
- Rna, Rnb: Spannungsteiler von Mn
- Rnc, Cn: Tiefpassfilterschaltung von Fn
- Sn: Messsignalausgang Empfänger Tn
- Sx: gemeinsamer Steuersignaleingang Empfänger
- Tn: optischer Empfänger, insbesondere Phototransistor
- Vcc: Referenzspannung

## Patentansprüche

1. Sensorschaltung mit mehreren optischen Sensoren, aufweisend:
einen ersten optischen Sensor mit einem ersten optischen Sender (D1) und einem ersten optischen Empfänger (T1), wobei der erste optische Sender (D1) mit einem ersten Steuersignaleingang (I1) verbunden ist und der erste optische Empfänger (T1) mit einem ersten Messsignalausgang (S1) verbunden ist; und
einen zweiten optischen Sensor mit einem zweiten optischen Sender (D2) und einem zweiten optischen Empfänger (T2), wobei der zweite optische Sender (D2) mit einem zweiten Steuersignaleingang (I2) verbunden ist und der zweite optische Empfänger (T2) mit einem zweiten Messsignalausgang (S2) verbunden ist;
**dadurch gekennzeichnet, dass**
der erste optische Empfänger (T1) und der zweite optische Empfänger (T2) mit einem gemeinsamen Steuersignaleingang (Sx) verbunden sind; und
eine erste Modulationseinrichtung (M1) zum Modulieren eines ersten Messsignals des ersten optischen Empfängers (T1) mit einem ersten Modulationsfaktor zwischen den ersten optischen Empfänger (T1) und den ersten Messsignalausgang (S1) geschaltet ist und eine zweite Modulationseinrichtung (M2) zum Modulieren eines zweiten Messsignals des zweiten optischen Empfängers (T2) mit einem zweiten Modulationsfaktor, der von dem ersten Modulationsfaktor verschieden ist, zwischen den zweiten optischen Empfänger (T2) und den zweiten Messsignalausgang (S2) geschaltet ist.

2. Sensorschaltung nach Anspruch 1, bei welcher
die erste Modulationseinrichtung (M1) einen ersten Spannungsteiler (R1a, R1b) mit einem ersten Spannungsteilungsverhältnis aufweist und die zweite Modulationseinrichtung (M2) einen zweiten Spannungsteiler (R2a, R2b) mit einem zweiten Spannungsteilungsverhältnis, das von dem ersten Spannungsteilungsverhältnis verschieden ist, aufweist.

3. Sensorschaltung nach Anspruch 2, bei welcher
der erste Spannungsteiler (R1a, R1b) einen ersten Widerstand (R1a) und einen zweiten Widerstand (R1b) aufweist und der zweite Spannungsteiler (R2a, R2b) einen ersten Widerstand (R2a) und einen zweiten Widerstand (R2b) aufweist, wobei die zweiten Widerstände (R1b, R2b) des ersten und des zweiten Spannungsteilers unterschiedliche Widerstandswerte haben.

4. Sensorschaltung nach einem der vorhergehenden Ansprüche, bei welcher eine erste Filtereinrichtung (F1) zwischen den ersten optischen Empfänger (T1) und den ersten Messsignalausgang (S1) geschaltet ist und eine zweite Filtereinrichtung (F2) zwischen den zweiten optischen Empfänger (T2) und den zweiten Messsignalausgang (S2) geschaltet ist.

5. Sensorschaltung nach Anspruch 4, bei welcher
die erste Filtereinrichtung (F1) eine erste Tiefpassfilterschaltung (R1c, C1) aufweist und die zweite Filtereinrichtung (F2) eine zweite Tiefpassfilterschaltung (R2c, C2) aufweist.

6. Sensorschaltung nach Anspruch 4 oder 5, bei welcher
die erste Filtereinrichtung (F1) zwischen die erste Modulationseinrichtung (M1) und den ersten Messsignalausgang (S1) geschaltet ist und die zweite Filtereinrichtung (F2) zwischen die zweite Modulationseinrichtung (M2) und den zweiten Messsignalausgang (S2) geschaltet ist.

7. Sensorschaltung nach einem der Ansprüche 1 bis 6, bei welcher
die Messsignalausgänge (Sn) der optischen Empfänger (Tn) jeweils mit einem ADC-Kanal eines Mikrocontrollers verbunden sind.

8. Sensorschaltung nach einem der Ansprüche 1 bis 6, bei welcher
die Messsignalausgänge (Sn) der optischen Empfänger (Tn) jeweils mit einem Eingang eines Multiplexers verbunden sind.

9. Sensorschaltung nach einem der vorhergehenden Ansprüche, bei welcher der erste optische Sender (D1) und der zweite optische Sender (D2) mit einem gemeinsamen Fehlersignalausgang (Ix) verbunden sind.

10. Bedienvorrichtung, insbesondere für ein elektronisches Haushaltsgerät, mit mehreren berührungs- und/oder annäherungsempfindlichen Bedienelementen und einer Sensorschaltung nach einem der vorhergehenden Ansprüche.

## Claims

1. Sensor circuit comprising a plurality of optical sensors, having:
a first optical sensor comprising a first optical transmitter (D1) and a first optical receiver (T1), wherein the first optical transmitter (D1) is connected to a first control signal input (I1) and the first optical receiver (T1) is connected to a first measurement signal output (S1); and
a second optical sensor comprising a second optical transmitter (D2) and a second optical receiver (T2), wherein the second optical transmitter (D2) is connected to a second control signal input (I2) and the second optical receiver (T2) is connected to a second measurement signal output (S2);
**characterized in that**
the first optical receiver (T1) and the second optical receiver (T2) are connected to a common control signal input (Sx); and
a first modulation device (M1) for modulating a first measurement signal of the first optical receiver (T1) using a first modulation factor is connected between the first optical receiver (T1) and the first measurement signal output (S1) and a second modulation device (M2) for modulating a second measurement signal of the second optical receiver (T2) using a second modulation factor, which is different from the first modulation factor, is connected between the second optical receiver (T2) and the second measurement signal output (S2).

2. Sensor circuit according to Claim 1, in which the first modulation device (M1) has a first voltage divider (R1a, R1b) having a first voltage division ratio and the second modulation device (M2) has a second voltage divider (R2a, R2b) having a second voltage division ratio, which is different from the first voltage division ratio.

3. Sensor circuit according to Claim 2, in which the first voltage divider (R1a, R1b) has a first resistor (R1a) and a second resistor (R1b) and the second voltage divider (R2a, R2b) has a first resistor (R2a) and a second resistor (R2b), wherein the second resistors (R1b, R2b) of the first and the second voltage divider have different resistance values.

4. Sensor circuit according to one of the preceding claims, in which a first filter device (F1) is connected between the first optical receiver (T1) and the first measurement signal output (S1) and a second filter device (F2) is connected between the second optical receiver (T2) and the second measurement signal output (S2).

5. Sensor circuit according to Claim 4, in which the first filter device (F1) has a first low-pass filter circuit (R1c, C1) and the second filter device (F2) has a second low-pass filter circuit (R2c, C2).

6. Sensor circuit according to Claim 4 or 5, in which the first filter device (F1) is connected between the first modulation device (M1) and the first measurement signal output (S1) and the second filter device (F2) is connected between the second modulation device (M2) and the second measurement signal output (S2).

7. Sensor circuit according to one of Claims 1 to 6, in which the measurement signal outputs (Sn) of the optical receivers (Tn) are each connected to an ADC channel of a microcontroller.

8. Sensor circuit according to one of Claims 1 to 6, in which the measurement signal outputs (Sn) of the optical receivers (Tn) are each connected to an input of a multiplexer.

9. Sensor circuit according to one of the preceding claims, in which the first optical transmitter (D1) and the second optical transmitter (D2) are connected to a common fault signal output (Ix).

10. Operating apparatus, in particular for an electronic household appliance, comprising a plurality of contact-sensitive and/or proximity-sensitive operating elements and a sensor circuit according to one of the preceding claims.

## Revendications

1. Circuit capteur comportant une pluralité de capteurs optiques, comportant :
un premier capteur optique comprenant un premier émetteur optique (D1) et un premier récepteur optique (T1), dans lequel le premier émetteur optique (D1) est connecté à une première entrée de signal de commande (I1) et le premier récepteur optique (T1) est connecté à une première sortie de signal de mesure (S1) ; et
un second capteur optique comprenant un second émetteur optique (D2) et un second récepteur optique (T2), dans lequel le second émetteur optique (D2) est connecté à une seconde entrée de signal de commande (I2) et le second récepteur optique (T2) est connecté à une seconde sortie de signal de mesure (S2) ;
**caractérisé en ce que** le premier récepteur optique (T1) et le second récepteur optique (T2) sont connectés à une entrée de signal de commande commune (Sx) ; et
**en ce qu'**un premier moyen de modulation (M1) destiné à moduler un premier signal de mesure du premier récepteur optique (T1) avec un premier facteur de modulation est connecté entre le premier récepteur optique (T1) et la première sortie de signal de mesure (S1), et **en ce qu'**un second moyen de modulation (M2) destiné à moduler un second signal de mesure du second récepteur optique (T2) avec un second facteur de modulation différent du premier facteur de modulation est connecté entre le second récepteur optique (T2) et la seconde sortie de signal de mesure (S2).

2. Circuit capteur selon la revendication 1, dans lequel
le premier moyen de modulation (M1) comprend un premier diviseur de tension (R1a, R1b) présentant un premier rapport de division de tension et le second moyen de modulation (M2) comprend un second diviseur de tension (R2a, R2b) présentant un second rapport de division de tension différent du premier rapport de division de tension.

3. Circuit capteur selon la revendication 2, dans lequel
le premier diviseur de tension (R1a, R1b) comporte une première résistance (R1a) et une seconde résistance (R1b) et le second diviseur de tension (R2a, R2b) comporte une première résistance (R2a) et une seconde résistance (R2b), dans lequel les secondes résistances (R1b, R2b) des premier et second diviseurs de tension ont des valeurs de résistance différentes.

4. Circuit capteur selon l'une des revendications précédentes, dans lequel
un premier dispositif de filtrage (F1) est connecté entre le premier récepteurs optique (T1) et la première sortie de signal de mesure (S1) et un second dispositif de filtrage (F2) est connecté entre le second récepteur optique (T2) et la seconde sortie de signal de mesure (S2).

5. Circuit capteur selon la revendication 4, dans lequel
le premier dispositif de filtrage (F1) comporte un premier circuit de filtrage passe-bas (R1c, C1) et le second dispositif de filtrage (F2) comporte un second circuit de filtrage passe-bas (R2c, C2).

6. Circuit capteur selon la revendication 4 ou 5, dans lequel
le premier dispositif de filtrage (F1) est connecté entre le premier dispositif de modulation (M1) et la première sortie de signal de mesure (S1) et le second dispositif de filtrage (F2) est connecté entre le second dispositif de modulation (M2) et la seconde sortie de signal de mesure (S2).

7. Circuit capteur selon l'une des revendications 1 à 6, dans lequel
les sorties de signal de mesure (Sn) des récepteurs optiques (Tn) sont respectivement connectées à un canal ADC d'un microcontrôleur.

8. Circuit capteur selon l'une des revendications 1 à 6, dans lequel
les sorties de signal de mesure (Sn) des récepteurs optiques (Tn) sont respectivement connectées à une entrée d'un multiplexeur.

9. Circuit capteur selon l'une des revendications précédentes, dans lequel
le premier émetteur optique (D1) et le second émetteur optique (D2) sont connectés à une sortie de signal d'erreur commune (Ix).

10. dispositif de commande, en particulier pour un appareil ménager électronique, comportant une pluralité d'éléments de commande sensibles au toucher et/ou sensibles à la proximité et un circuit capteur selon l'une des revendications précédentes.
